# EUROPEAN PATENT APPLICATION

(11) **EP 4 632 392 A1**
(43) Date of publication of application: **15.10.2025**
(21) Application number: 23900351.0
(22) Date of filing: 31.10.2023
(51) Int. Cl.: G01R 1/067, G01R 31/26, G01R 31/28

(54) **PROBE**

(30) Priority: 08.12.2022 JP 2022196254
(71) Applicant: Kabushiki Kaisha Nihon Micronics, Musashino-shi Tokyo 180-8508 (JP)
(72) Inventor: AKAHIRA Akihisa, Musashino-shi, Tokyo 180-8508 (JP); NARITA Hisao, Musashino-shi, Tokyo 180-8508 (JP); HAYASHIZAKI Takayuki, Musashino-shi, Tokyo 180-8508 (JP); KON Mizuho, Musashino-shi, Tokyo 180-8508 (JP); SUTO Kenichi, Musashino-shi, Tokyo 180-8508 (JP)
(74) Representative: Samson & Partner Patentanwälte mbB
(86) International application number: PCT/JP2023/039314
(87) International publication number: WO 2024/122229

(57) **Abstract**

A probe has a column shape including a structure in which a contact part, a curved part, and a connection part configured to connect the contact part and the curved part are connected in an axial direction. A cross-section of the curved part and the connection part perpendicular to the axial direction has a structure in which a first member and a second member having a lower hardness than the first member are mixed. An area ratio of the second member to the first member in the cross-section is higher in the curved part than in the connection part.

## Description

### TECHNICAL FIELD

The present invention relates to a probe used for inspecting the electrical characteristics of an inspection object.

### BACKGROUND ART

In order to inspect the electrical characteristics of an inspection object such as a semiconductor integrated circuit in a wafer state, an electrical connection apparatus including a probe is used. In inspection using a probe, one end of the probe is brought into contact with an electrode pad of the inspection object, and the other end of the probe is brought into contact with a terminal (hereinafter, referred to as "land") arranged on a printed circuit board or the like. The land is electrically connected to an inspection device such as a tester.

In inspection of an inspection object, after the probe is brought into contact with an electrode pad, the electrical connection apparatus and the inspection object are brought closer to each other to curve the probe by elastic deformation. As the probe is curved in this way, the probe can be stably brought into contact with the electrode pad and the land by the elastic force of the probe.

### CITATION LIST

### PATENT LITERATURE

Patent Literature 1: JP 2018-91870 A

### SUMMARY OF INVENTION

### PROBLEMS TO BE SOLVED BY INVENTION

There is a need to reduce the diameter of a probe along with the tendency of a narrow pitch between the electrode pads of an inspection object. However, along with the tendency of reducing the diameter of the probe, a problem arises that the mechanical strength of the probe decreases when the probe is curved. Therefore, an object of the present invention is to provide a probe having improved mechanical strength when the probe is curved.

### SOLUTION TO SOLVE PROBLEMS

A prove according to an aspect of the present invention has a column shape including a structure in which a contact part, a curved part, and a connection part configured to connect the contact part and the curved part are connected in an axial direction. A cross-section of the curved part and the connection part perpendicular to the axial direction has a structure in which a first member and a second member having a lower hardness than the first member are mixed. An area ratio of the second member to the first member in the cross-section is higher in the curved part than in the connection part.

### EFFECTS OF INVENTION

The present invention makes it possible to provide a probe having improved mechanical strength when the probe is curved.

### BRIEF DESCRIPTION OF DRAWINGS

[FIG. 1] FIG. 1 is a schematic diagram illustrating a configuration of a probe according to an embodiment of the present invention.
[FIG. 2] FIG. 2 is a schematic cross-sectional view taken along the II-II direction of FIG. 1.
[FIG. 3] FIG. 3 is a schematic cross-sectional view taken along the III-III direction of FIG. 1.
[FIG. 4] FIG. 4 is a schematic cross-sectional view taken along the IV-IV direction of FIG. 1.
[FIG. 5] FIG. 5 is a schematic cross-sectional view taken along the V-V direction of FIG. 1.
[FIG. 6] FIG. 6 is a schematic diagram illustrating the configuration of an electrical connection apparatus having probes according to the embodiment of the present invention.
[FIG. 7] FIG. 7 is a schematic diagram illustrating a configuration of an electrical connection apparatus having probes according to a modified example of the embodiment of the present invention.
[FIG. 8] FIG. 8 is a schematic cross-sectional view taken along the VIII-VIII direction of FIG. 7.

### DESCRIPTION OF EMBODIMENT

An embodiment of the present invention will be described below with reference to the drawings. The same or similar elements illustrated in the drawings are denoted by the same or similar reference numerals. However, the drawings are illustrated schematically, and it should be noted that the proportions of the thicknesses or lengths of the respective parts and so forth are not drawn to scale. It should also be understood that the relationships or proportions of the dimensions between the respective drawings are different from each other in some elements. The embodiment described below exemplify a device and a method for embodying a technical idea of the present invention. In the embodiment of the present invention, the material, shape, structure, arrangement, manufacturing method and the like of the components are not limited to the following description.

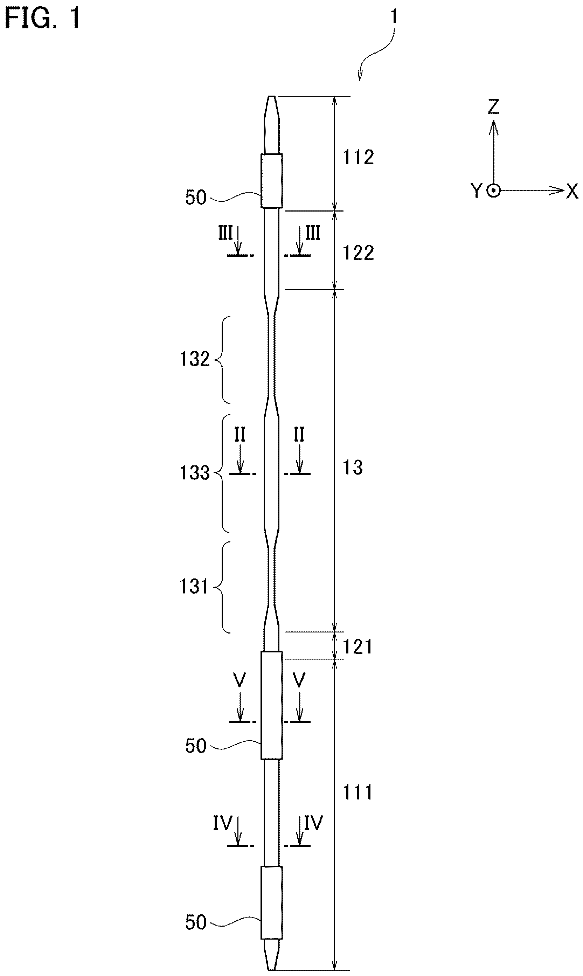

A probe 1 according to an embodiment illustrated in FIG. 1 is used for inspecting the electrical characteristics of an inspection object. The probe 1 has a column shape including a structure in which a first contact part 111, a first connection part 121, a curved part 13, a second connection part 122, and a second contact part 112 are connected in order along the axial direction. In the following description, when not limiting the first contact part 111 and the second contact part 112 individually, they are referred to as a contact part 11. Further, when not limiting the first connection part 121 and the second connection part 122 individually, they are referred to as a connection part 12. In other words, the probe 1 includes the contact part 11, the curved part 13, and the connection part 12 configured to connect the contact part 11 and the curved part 13.

The first connection part 121 connects the first contact part 111 and the curved part 13. The second connection part 122 connects the second contact part 112 and the curved part 13. The tip of the first contact part 111 comes into contact with an inspection object (not illustrated) in inspection. The tip of the second contact part 112 comes into contact with a land in inspection of the inspection object. As will be described later, the probe 1 is curved by elastic deformation at the time of inspection of the inspection object.

In the description of the embodiment of the present invention, the X, Y and Z directions are defined as illustrated in FIG. 1. In FIG. 1, the X direction is parallel to the left-right direction of the page space, the Y direction is parallel to the depth direction of the page space, and the Z direction is parallel to the up-down direction of the page space. The axial direction of the probe 1 is along the Z direction. In the following description, a case will be described in which the probe 1 has a rectangular cross-section perpendicular to the axial direction. Further, the X direction is defined as the width direction of the probe 1, and the Y direction is defined as the thickness direction of the probe 1.

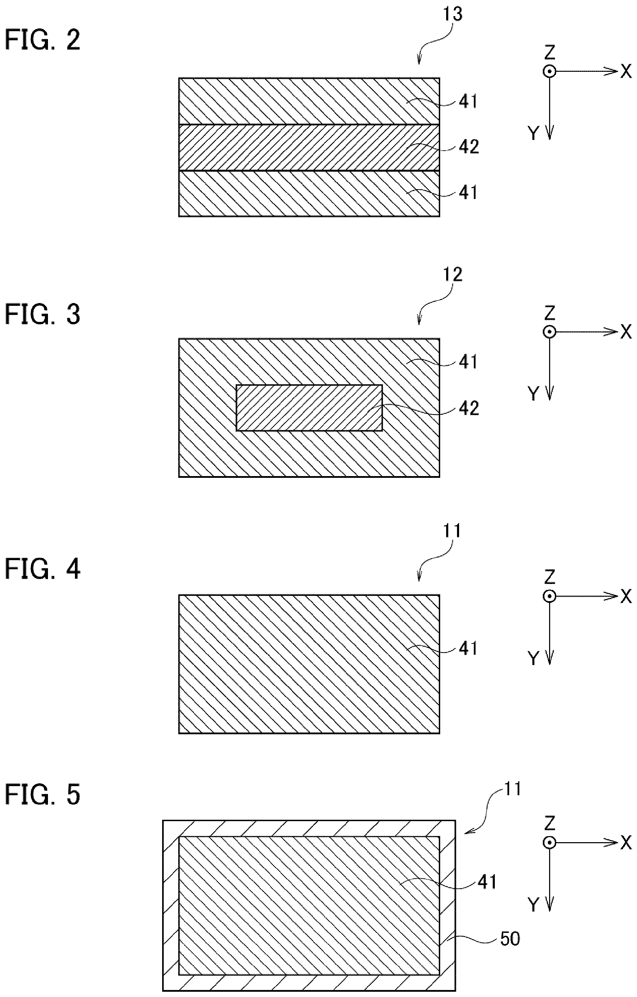

FIG. 2 illustrates a structure of the cross-section of the curved part 13 perpendicular to the axial direction along the II-II direction of FIG. 1 (hereinafter, simply referred to as "cross-section"). FIG. 3 illustrates a structure of the cross-section of the connection part 12 along the III-III direction of FIG. 1. In the probe 1, the cross-section of the curved part 13 and the connection part 12 has a structure in which a first member 41 and a second member 42 having a lower hardness than the first member 41 are mixed. In the following description, the structure in which the first member 41 and the second member 42 are mixed is also referred to as a "mixed structure". For example, as illustrated in FIGS. 2 and 3, the mixed structure in the curved part 13 and the connection part 12 may include a layered structure in which the second member 42 is sandwiched between the first members 41. This layered structure is a structure in which the first member 41 and the second member 42 are layered in the thickness direction of the probe 1 (Y direction).

The first member 41 and the second member 42 are selected such that the second member 42 has a lower hardness than the first member 41. The conductivity of the second member 42 is preferably higher than that of the first member 41. For example, nickel (Ni), nickel alloy, or the like is used for the first member 41. Gold (Au), silver (Ag), copper (Cu), or the like is used for the second member 42.

In the probe 1, an area ratio of the second member 42 to the first member 41 in the cross-section is set higher in the curved part 13 than in the connection part 12. For example, as illustrated in FIG. 2, the curved part 13 may have a sandwich structure in which the second member 42 is sandwiched in the thickness direction between the first members 41 having the same width as the second member 42. Meanwhile, in the connection part 12, the second member 42 may be surrounded by the first member 41, as illustrated in FIG. 3. As the thickness of the second member 42 is set to be approximately the same in the connection part 12 and in the curved part 13, the area ratio of the second member 42 to the first member 41 in the cross-section is higher in the curved part 13 than in the connection part 12. The probe 1 may be formed such that each of the first member 41 and the second member 42 is continuous from the connection part 12 to the curved part 13.

As described above, in the probe 1, the area ratio of the second member 42 to the first member 41 in the cross-section is higher in the curved part 13 than in the connection part 12, and the second member 42 has a lower hardness than the first member 41. Therefore, the connection part 12 has a higher rigidity than the curved part 13. In other words, when the probe 1 deforms elastically, the curved part 13 is more likely to be curved than the connection part 12.

The rigidity of the contact part 11 is set higher than that of the connection part 12. For example, as illustrated in FIG. 4, the entire contact part 11 may be the first member 41. Since the contact part 11 does not include the second member 42, the rigidity of the contact part 11 is higher than that of the connection part 12 and the curved part 13. Therefore, when the probe 1 deforms elastically, the curvedness of the contact part 11 is suppressed.

As described above, the probe 1 has a configuration in which the connection part 12, which is less curved than the curved part 13 and has a lower rigidity than the contact part 11, is arranged between the curved part 13 and the contact part 11. Therefore, in inspection of the inspection object, the probe 1 is greatly curved in the curved part 13, and the curvedness of the probe 1 is suppressed more in the connection part 12 than in the curved part 13. As described above, the connection part 12 and the curved part 13 which differ from each other in ease of curvedness are continuous, thereby reducing the stress concentration when the probe 1 is curved, and ensuring the straightness of the contact part 11.

As illustrated in FIG. 5, a portion of the region of the contact part 11 may be surrounded to be covered by a protective material 50 having a higher hardness than the contact part 11. For example, a rhodium (Rh) material is suitably used as the protective material 50. By arranging the protective material 50 on the outer periphery of the probe 1, the damage to the probe 1 due to contact with something outside the probe 1 can be suppressed. In FIG. 5, a case in which the protective material 50 covers the outer periphery of the contact part 11 has been described as an example; however, the protective material 50 may not cover the entire outer periphery of the contact part 11. For example, one long side and two short sides of the cross-section may be covered by the protective material 50.

As illustrated in FIG. 1, the area of the cross-section of the region of the curved part 13 connected to the connection part 12 may be smaller than the area of the cross-section of the other region of the curved part 13. In the following description, the region of the curved part 13 of the probe 1 connected to the connection part 12 is also referred to as a "connection region". Further, in the following description, the remaining region of the curved part 13 excluding the connection region is also referred to as an "intermediate region". The curved part 13 illustrated in FIG. 1 includes an intermediate region 133, a first connection region 131 connected to one end of the intermediate region 133, and a second connection region 132 connected to the other end of the intermediate region 133. The first connection region 131 is connected to the first connection part 121, and the second connection region 132 is connected to the second connection part 122. In the following description, when not limiting the first connection region 131 and the second connection region 132 individually, they are referred to as a connection region 130.

In the curved part 13, as the area of the cross-section of the connection region 130 is set to be smaller than that of the intermediate region 133, when the probe 1 is curved, the connection region 130 is curved particularly greatly between the intermediate region 133 and the connection part 12. Therefore, the straightness of the contact part 11 which is connected to the connection part 12 on the side opposite to the curved part 13 can be further ensured. For example, as illustrated in FIG. 1, as the width of the connection region 130 is set to be smaller than that of the intermediate region 133 in the X direction, the area of the cross-section of the connection region 130 may be smaller than that of the intermediate region 133. At this time, the thickness of the curved part 13 is constant when viewed from the X direction.

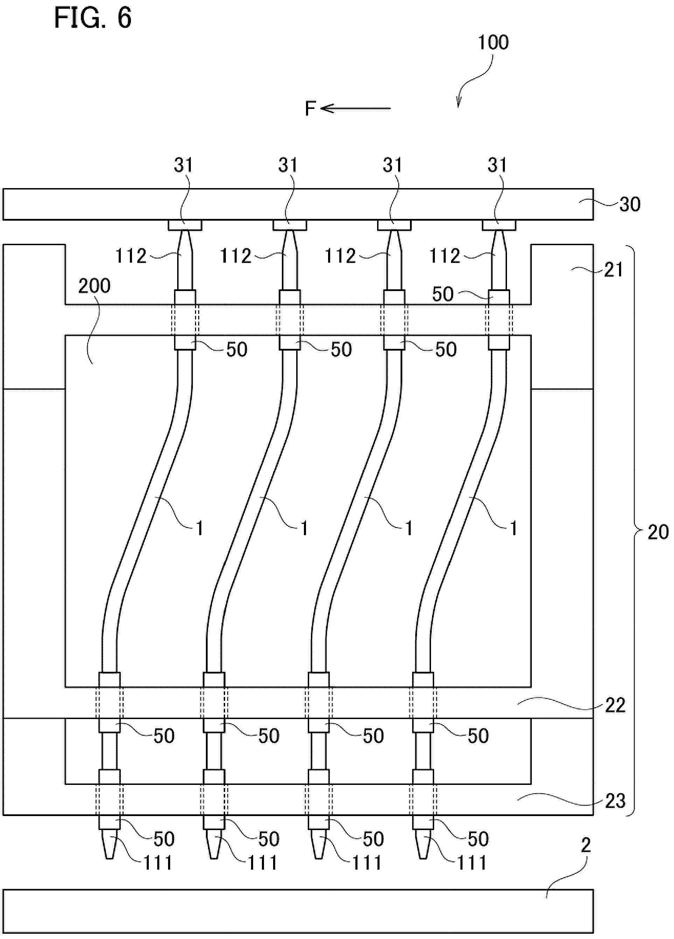

The probe 1 is used in the electrical connection apparatus 100 illustrated in FIG. 6, for example. In the electrical connection apparatus 100, the probe 1 is held by a probe head 20. Specifically, the probe 1 is inserted into a guide hole of a first guide plate 21, a guide hole of a second guide plate 22, and a guide hole of a third guide plate 23 which are included in the probe head 20, and thus a plurality of probes 1 are held by the probe head 20. In the following description, when not limiting the first guide plate 21, the second guide plate 22, and the third guide plate 23 individually, they are referred to as a guide plate. The probe head 20 has a configuration in which the first guide plate 21, the second guide plate 22, and the third guide plate 23 are arranged apart from each other in the surface normal direction of the main surfaces of the guide plates.

The first contact part 111 of the probe 1 comes into contact with an electrode pad (not illustrated) of an inspection object 2 at the time of inspection of the inspection object 2. The second contact part 112 of the probe 1 comes into contact with a land 31 of a substrate 30. The land 31 is electrically connected to an inspection device such as an IC tester (not illustrated).

In the electrical connection apparatus 100 illustrated in FIG. 6, regarding the guide holes through which the same probe 1 penetrates, the position of the guide hole of the second guide plate 22 is arranged so as to be shifted in a direction F parallel to the main surface of the first guide plate 21 with respect to the guide hole of the first guide plate 21. In the following description, an arrangement in which the position of the guide hole is shifted is referred to as an "offset arrangement". Further, the direction F in which the position of the guide hole is shifted is referred to as an "offset direction". Due to the offset arrangement, the probe 1 is curved between the first guide plate 21 and the second guide plate 22. That is, in a hollow region 200 between the first guide plate 21 and the second guide plate 22, the probe 1 is curved by elastic deformation. For example, the offset direction is the direction in which the long sides of the probe 1 having a rectangular cross-section are oriented. The position of the guide hole of the second guide plate 22 and the position of the guide hole of the third guide plate 23 coincide with each other when viewed from the surface normal direction of the guide plates.

Since the guide hole of the first guide plate 21 and the guide hole of the second guide plate 22 are arranged in an offset manner, when the first contact part 111 of the probe 1 comes into contact with the inspection object 2, the probe 1 buckles in the hollow region 200. That is, in a state in which the probe 1 comes into contact with the inspection object 2 (contact state), the probe 1 is further curved by deflection deformation from the curved shape in a state in which the probe 1 is not into contact with the inspection object 2 (non-contact state). As the probe 1 is further curved in this way, the probe 1 comes into contact with the inspection object 2 with a predetermined pushing force. Therefore, the offset arrangement makes it possible to measure the electrical characteristics of the inspection object 2 stably using the probe 1. In the non-contact state, the probe 1 has elasticity to return to the shape before coming into contact with the inspection object 2.

When the probe 1 is curved in the contact state, the connection part 12 and the curved part 13 are curved. In particular, the curved part 13 in which the ratio of the second member 42 to the first member 41 is higher than the connection part 12 tends to be curved. Since the connection part 12, which is less curved than the curved part 13 and has a lower rigidity than the contact part 11, is arranged between the curved part 13 and the contact part 11, the contact part 11 moves linearly along the central axis of the guide hole of the guide plate even when the probe 1 is curved at the time of the inspection of the inspection object 2. Therefore, the damage to the probe 1 due to contact between the probe 1 and the side surface of the guide hole of the guide plate can be suppressed. Note that "the side surface" of the guide hole includes the inner wall surface and the opening of the guide hole.

Further, when the curved part 13 includes the intermediate region 133 and the connection region 130, the probe 1 is greatly curved in the connection region 130. This further makes it possible for the contact part 11 to move linearly along the guide hole. As a result, the damage to the probe 1 due to contact between the side surface of the guide hole and the contact part 11 can be suppressed. However, if the contact between the side surface of the guide hole and the contact part 11 can be suppressed even if the curved part 13 does not include the connection region 130, the diameter of the curved part 13 may be constant.

In addition, by arranging the protective material 50 having a higher hardness than the contact part 11 around the region of the contact part 11 of the probe 1 passing through the guide hole, the damage to the probe 1 due to contact with the side surface of the guide hole can be suppressed. In the probes 1 illustrated in FIG. 6, the protective materials 50 are arranged in the regions passing through the guide holes of the second guide plate 22 and the third guide plate 23 in the first contact part 111, and in the regions passing through the guide holes of the first guide plate 21 in the second contact part 112.

The protective material 50 may cover a portion of the connection part 12 beyond the connected portion between the contact part 11 and the connection part 12. That is, the region of the connection part 12 near the contact part 11 may be covered by the protective material 50, and the region of the connection part 12 near the curved part 13 may not be covered by the protective material 50. By covering the region of the connection part 12 near the contact part 11 with the protective material 50, even if a portion of the connection part 12 passes through the inner side of the guide hole, the damage to the probe 1 due to contact with the side surface of the guide hole can be suppressed. Even in the region covered by the protective material 50, the connection part 12 has a mixed structure of the first member 41 and the second member 42. As the region covered by the protective material 50 is also configured so as to have a mixed structure, it is possible to prevent stress from being concentrated on the connection part 12 in a state in which the probe 1 is curved.

As described above, in the probe 1 according to the embodiment of the present invention, since the ratio of the second member 42 in the cross-section of the curved part 13 is larger than that of the connection part 12, the curved part 13 tends to be curved more easily than the connection part 12. Since the connection part 12 and the curved part 13 which differ from each other in ease of curvedness are continuous, it is possible to reduce the stress concentration when the probe 1 is curved. Therefore, the mechanical strength of the probe 1 when curved can be improved even if the diameter of the probe 1 is reduced along with the tendency of a narrow pitch between the electrode pads of the inspection object.

### <Modified example>

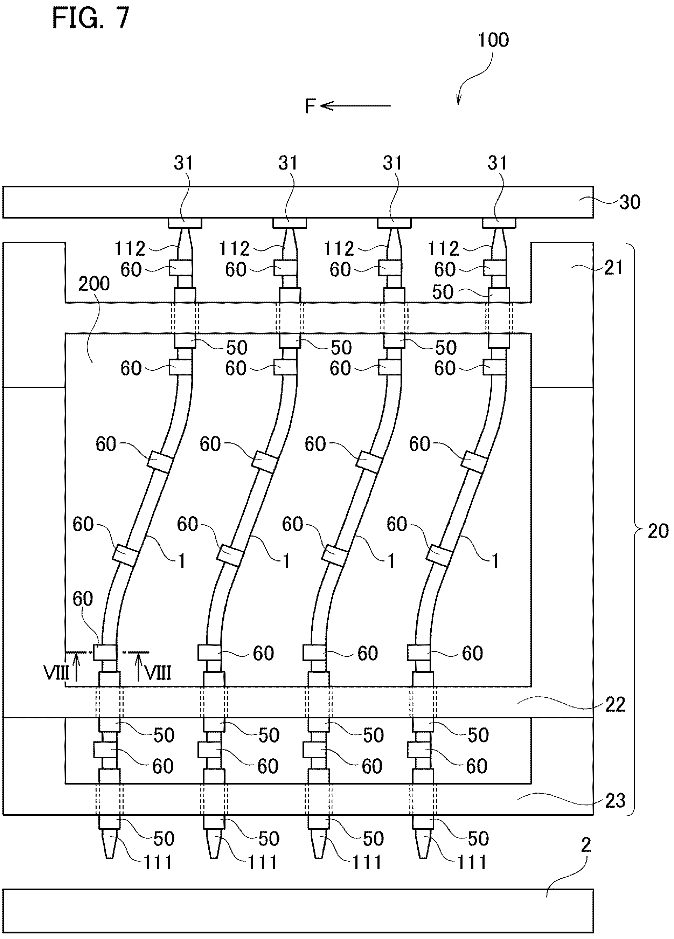

In the probe 1 according to a modified example of the embodiment illustrated in FIG. 7, a plurality of insulating covering materials 60 are arranged apart from each other on the surface of the probe 1 along the axial direction of the probe 1. The covering materials 60 are arranged in the remaining regions of the regions in which the protective materials 50 are arranged.

When the probe 1 buckles at the inner inside of the probe head 20 at the time of inspection of an inspection object, a short circuit between the probes may occur. In the electrical connection apparatus 100 illustrated in FIG. 7, the insulating covering materials 60 arranged on the surface of the probe 1 are brought into contact with the adjacent probes 1, thereby preventing a short circuit between the probes.

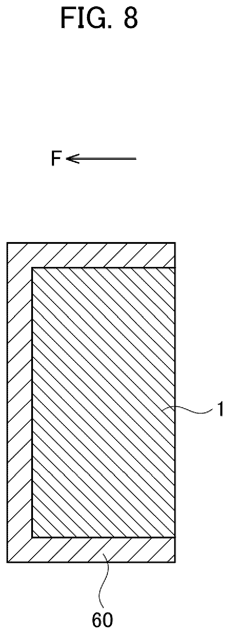

It is preferable that the covering material 60 be arranged on the side surface of the probe 1 oriented in the offset direction (hereinafter referred to as "offset side surface"), or on the side surface oriented in the direction opposite to the offset side surface. For example, as illustrated in FIG. 8, the covering material 60 may be continuously arranged on the offset side surface of the probe 1 having a rectangular cross-section and on two side surfaces adjacent to the offset side surface. Alternatively, the covering material 60 may be arranged over the entire circumference of the probe 1.

Each of the covering materials 60 is intermittently arranged, including at least the curved portion, in the portion passing through the hollow region 200 of the probe 1. In contrast, if the surface of the probe 1 is continuously covered by the covering materials 60 along the axial direction from the first contact part 111 to the second contact part 112, the warpage of the probe 1 tends to occur. However, in the probe 1 illustrated in FIG. 7, the warpage of the probe 1 is suppressed by intermittently arranging the covering materials 60 along the axial direction.

Meanwhile, in order to set the probe 1 in the probe head 20, the probe 1 is made to penetrate through the guide holes of the guide plates. For example, the probe 1 is made to penetrate continuously through the guide holes of the guide plates in a state in which the center axes of the guide holes of all the guide plates are aligned. Therefore, the sum of the outer diameter of the probe 1 and the thickness of the covering materials 60 is set smaller than the inner diameters of the guide holes. That is, the thickness of the covering materials 60 is set to the thickness in a range that ensures a clearance between the sum of the outer diameter of the probe 1 and the thickness of the covering materials 60 and the inner diameter of the guide holes, and to the thickness that prevents a short circuit between the probes.

The material of the covering material 60 may be, for example, resin, glass fiber, permanent resist, ceramic vapor deposition, or the like. In order to form the covering material 60 at a predetermined position on the surface of the probe 1, for example, the covering material 60 may be formed over the entire surface of the probe 1, and then the covering material 60 may be patterned using a photolithography technique or the like.

### (Other embodiments)

The embodiment of the present invention has been described as above, but the statements and drawings forming part of this disclosure should not be understood as limiting the invention. Various alternative embodiments, examples, and operating techniques will be apparent to those skilled in the art from this disclosure.

Although the case has been described above in which the probe 1 has a rectangular cross-sectional shape; however, the probe 1 may have a different cross-sectional shape. For example, the probe 1 may have a polygonal cross-sectional shape other than a rectangular cross-sectional shape. No matter what shape the cross-section of the base material 10 has, the area ratio of the second member 42 to the first member 41 in the mixed structure of the cross-section is made higher in the curved part 13 than in the connection part 12. Thus, the curved part 13 can be curved more easily than the connection part 12.

Thus, the present invention will of course include various embodiments and the like which are not described herein.

### REFERENCE SIGNS LIST

- 1: Probe
- 11: Contact part
- 12: Connection part
- 13: Curved part
- 20: Probe head
- 21: First guide plate
- 22: Second guide plate
- 23: Third guide plate
- 30: Substrate
- 31: Land
- 41: First member
- 42: Second member
- 50: Protective material
- 100: Electrical connection apparatus
- 111: First contact part
- 112: Second contact part
- 121: First connection part
- 122: Second connection part
- 130: Connection region
- 133: Intermediate region

## Claims

1. A probe used for inspecting electrical characteristics of an inspection object, wherein
the probe has a column shape including a structure in which a contact part, a curved part, and a connection part configured to connect the contact part and the curved part are connected in an axial direction,
a cross-section of the curved part and the connection part perpendicular to the axial direction has a structure in which a first member and a second member having a lower hardness than the first member are mixed, and
an area ratio of the second member to the first member in the cross-section is higher in the curved part than in the connection part.

2. The probe according to claim 1, wherein
a rigidity of the contact part is higher than that of the connection part.

3. The probe according to claim 1 or 2, wherein
a first contact part, a first connection part, the curved part, a second connection part, and a second contact part are connected in order along the axial direction.

4. The probe according to claim 1 or 2, wherein
the cross-section includes a structure in which the second member is sandwiched between first members.

5. The probe according to claim 1 or 2, wherein
in the connection part, the second member is surrounded by the first member.

6. The probe according to claim 1 or 2, wherein
an area of the cross-section of a connection region of the curved part connected to the connection part is smaller than an area of the cross-section of a remaining region of the curved part excluding the connecting region.

7. The probe according to claim 1 or 2, wherein
a portion of a region of the contact part is surrounded to be covered by a protective material having a higher hardness than the contact part.

8. The probe according to claim 7, wherein
the protective material covers a portion of the connection part beyond a connected portion between the contact part and the connection part.
